# FASCICULE DE BREVET EUROPEEN

(11) **EP 4 519 057 B1**
(45) Date de publication et mention de la délivrance du brevet: **03.06.2026**
(21) Numéro de dépôt: 23727655.5
(22) Date de dépôt: 28.04.2023
(51) Int. Cl.: B29C 45/14, H05K 3/00, H05K 1/16, H05K 1/02

(54) **PROCÉDÉ D'OBTENTION D'UNE PIÈCE À FONCTION ÉLECTRONIQUE INTÉGRÉE**
VERFAHREN ZUR HERSTELLUNG EINES TEILS MIT INTEGRIERTER ELEKTRONISCHER FUNKTION
METHOD FOR OBTAINING A PART WITH INTEGRATED ELECTRONIC FUNCTION

(30) Priorité: 02.05.2022 FR 2204161
(43) Date de publication de la demande: 12.03.2025
(73) Titulaire: Université de Rennes, 35042 Rennes (FR); Institut National des Sciences Appliquées de Rennes, 35700 Rennes (FR); CentraleSupélec, 91190 - Gif sur Yvette (FR); Nantes Université, 44000 Nantes (FR); Centre National de la Recherche Scientifique, 75016 Paris (FR)
(72) Inventeur: HARNOIS, Maxime, 35000 Rennes (FR); HERRY, Gaëtan, 91520 Egly (FR); FUSTEC, Jean-Charles, 22310 Plestin-Les-Grèves (FR)
(74) Mandataire: Cabinet Chaillot
(86) Numéro de dépôt international: PCT/IB2023/054472
(87) Numéro de publication internationale: WO 2023/214279

(56) Documents cités:
- EP-B1- 3 042 784
- WO-A1-2009/131091
- WO-A1-2018/163184
- CN-A- 110 832 039

## Description

La présente invention porte sur un procédé d'obtention d'une pièce à fonction électronique intégrée.

Les fonctions électroniques en deux dimensions planaires jouent un rôle clé dans la vie quotidienne. La croissance des objets qui intègrent des fonctions électroniques est exponentielle et le défi des concepteurs est d'intégrer de telles fonctions électroniques, par exemple à la surface d'objets complexes en trois dimensions.

On connaît par le document WO 2018/138283, un procédé d'impression par transfert par un solvant pour appliquer un matériau non soluble, et non dispersible, tel qu'un semi-conducteur, sur la surface d'un objet.

Selon le procédé décrit dans de document :
- on forme un motif sur une surface d'un substrat soluble dans un solvant (par lithographie, gravure, impression par jet d'encre) ;
- on dépose le substrat sur la surface d'un bain de solvant, sur le côté du substrat opposé au côté sur lequel le motif est appliqué pour dissoudre partiellement le substrat ;
- on plonge l'objet à revêtir dans le bain de telle sorte que l'objet vienne en contact avec le motif ;
- on sort l'objet avec le motif appliqué hors du bain ; et
- on sèche l'objet.

Un tel procédé forme directement le semi-conducteur sur la surface de la pièce finale. La pièce finale étant plongée dans le bain, il est seulement possible de transférer le semi-conducteur sur une pièce finale de forme convexe. Il n'est alors pas possible de transférer le semi-conducteur sur une pièce de forme concave car dans ce cas, du liquide du bain resterait piégé dans la cavité de la pièce.

Le document WO 2018/163184 décrit un procédé de fabrication d'un motif conducteur sur un objet tridimensionnel (3D), comprenant l'hydro-impression d'un motif planaire conducteur bidimensionnel (2D) sur un substrat sacrificiel 2D, et le transfert du motif sur l'objet 3D. Le document WO 2009/131091 décrit un film de transfert pour former un tracé de circuit permettant la formation d'un tracé de circuit sur une surface incurvée qui présente une grande courbure, sans apparition de coupure.

Les objets tridimensionnels présentant des formes d'une grande complexité, il serait intéressant de pouvoir disposer d'une solution pour permettre le transfert d'une fonction électronique sur une surface complexe présentant des parties concaves ou présentant à la fois des parties concaves et convexes.

Les demandeurs proposent une solution à ce problème en utilisant un conformateur qui présente une surface convexe sur laquelle sera placée une fonction électronique et qui servira par la suite de moule pour former une pièce présentant une région concave et qui présentera alors la fonction électronique.

A cet effet, la présente invention porte sur un procédé d'obtention d'une pièce à fonction électronique intégrée, ladite pièce présentant au moins une région de surface concave dans laquelle on souhaite placer une fonction électronique, caractérisé par le fait qu'il comprend les étapes consistant à :
(a) se procurer un substrat temporaire flexible fait d'un matériau apte à se dissoudre dans un bain de liquide tout en restant à sa surface et à revenir à son état préalable par séchage une fois sorti du bain ;
(b) se procurer un conformateur présentant au moins une région de surface convexe apte à s'apparier avec ladite au moins une région de surface concave à la manière de deux parties complémentaires d'un moule ;
(c) former une fonction électronique sur l'une des faces du substrat temporaire ;
(d) placer le substrat temporaire portant la fonction électronique dans le bain de liquide afin de former un film liquide sur la surface du bain de liquide ;
(e) transférer la fonction électronique et le film qui la porte sur ladite au moins une surface convexe du conformateur, de façon à former la succession suivante : - conformateur - couche de substrat temporaire - fonction électronique ;
(f) retirer le conformateur du bain de liquide et faire sécher pour faire revenir le substrat temporaire à son état initial ;
(g) mouler la pièce sur le conformateur pour former la succession suivante : - conformateur - couche de substrat temporaire - fonction électronique - pièce ;
(h) retirer le conformateur afin **d'obtenir** la pièce à fonction électronique intégrée revêtue du substrat temporaire, lequel peut être conservé en tant que substrat de recouvrement de la fonction électronique, ou être retiré.

Comme substrat temporaire, on peut donc utiliser tout substrat ayant une épaisseur lui permettant de « flotter » puis de se dissoudre dans le liquide du bain comme indiqué ci-dessus. A titre d'exemple, une telle épaisseur est de 10-50 µm.

Dans un mode réalisation particulier, on utilise comme substrat temporaire une feuille de poly(alcool de vinyle). On peut utiliser un tel substrat temporaire lorsque la fonction électronique est constituée de motifs ne nécessitant pas le passage par des étapes de photolithographie ou de matériaux pouvant être mise en forme à une température inférieure à 100°C.

Dans un mode de réalisation particulier, on forme sur un substrat de support, une couche de substrat temporaire avec interposition d'une couche sacrificielle, ayant la propriété de se dissoudre facilement dans le bain de liquide et / ou un pouvoir d'adhésion faible ou nul avec la couche de substrat temporaire, et on utilise cet assemblage pour conduire l'étape (c), puis on amène la couche de support et la couche sacrificielle à être retirées à l'étape (d). La couche sacrificielle peut être une couche non-adhésive en poly(méthacrylate de méthyle). On peut utiliser un tel substrat temporaire lorsque la fonction électronique est constituée de motifs nécessitant le passage par des étapes de photolithographie ou l'utilisation de matériaux élaborés à des températures supérieures à 100°C

Dans le procédé selon la présente invention, on peut utiliser un conformateur constitué par tout matériau non soluble dans le liquide et pouvant être mis en forme par des techniques classiques, telles que l'usinage et le moulage. A titre d'exemple, on peut mentionner les pièces métalliques, en matière plastique, en composite ou en silicone.

On peut former la fonction électronique par une technique choisie parmi l'impression par jet d'encre, la sérigraphie, le marquage par estampage et la photolithographie.

Le bain de liquide peut être un bain d'eau à une température de 25 à 40°C.

A l'étape (d) la fonction électronique peut être :
- placée sur le film formé sur la surface du bain de liquide, et
   ∘ à l'étape (e), le conformateur est placé dans le fond du bain de liquide et le conformateur remonte à la surface du bain de liquide ou la surface du bain de liquide descend afin de transférer la fonction électronique et le film qui la porte sur ladite au moins une surface convexe du conformateur ;
      ou
- placée sous le film formé sur la surface du bain de liquide, et
   ∘ à l'étape (e), le conformateur est placé au-dessus du bain de liquide et le conformateur plonge dans le bain de liquide ou la surface du bain de liquide monte afin de transférer la fonction électronique et le film qui la porte sur ladite au moins une surface convexe du conformateur.

On peut conduire le séchage de l'étape (f) à une température de 25 à 60°C pendant une durée de 5 heures à 30 minutes.

On peut conduire le moulage de l'étape (g) à partir d'une résine compatible avec les procédés de moulage, de fabrication de matériaux composites, etc., bien connue de l'homme du métier.

La présente invention porte également sur un procédé tel que défini ci-dessus, suivant lequel la pièce comporte également au moins une région de surface convexe dans laquelle on souhaite également placer une fonction électronique, caractérisé par le fait que :
- à l'étape (b), on se procure un conformateur en un matériau capable de se déformer pour permettre de le conformer avec la ou les formes concaves et avec la ou les formes convexes souhaitées pour s'apparier avec les formes complémentaires de la pièce à construire ;
- avant l'étape (e), on déforme le conformateur pour que toutes ses régions déformables soient des régions convexes ;
- on conduit l'étape (e) comme indiqué ci-dessus ;
- avant l'étape (g), on déforme la ou les régions qui doit(doivent) correspondre aux régions convexes de la pièce pour qu'elle(s) aie(nt) une forme concave.

On peut alors utiliser un conformateur formé par une feuille d'élastomère, tel que du polydiméthylsiloxane.

En particulier, on peut utiliser un conformateur à l'état appliqué sur un socle de forme complémentaire de la pièce que l'on veut obtenir, ledit socle n'étant pas modifié au cours du procédé. Le socle peut être formé de tout matériau non soluble dans le liquide et pouvant être mis en forme par des techniques classiques, telles que l'usinage et le moulage. A titre d'exemple, on peut mentionner les pièces métalliques, en matière plastique, en composite, en silicone.

Les exemples suivants illustrent la présente invention sans toutefois en limiter la portée.

### Mode opératoire général

### Etape (a) Formation d'un substrat temporaire

Dans le cadre de la présente invention, la fonction électronique est formée sur un substrat temporaire.

Deux variantes sont possibles en fonction des matériaux qui constituent la fonction électronique.

### Première variante

Dans le cas où la fonction électronique est constituée de motifs ne nécessitant pas le passage par des étapes de photolithographie ou de matériaux pouvant être mise en forme à une température inférieure à 100°C, des techniques de fabrication additive peuvent être utilisées. Ces techniques comprennent l'impression par jet d'encre, la sérigraphie ou le marquage par estampage.

Des matériaux facilement dissolvables ou facilement détachables par arrachement de la fonction électronique peuvent alors être utilisés pour fabriquer le substrat temporaire 100. On peut par exemple citer un substrat flexible de poly(alcool de vinyle) (PVA) fabriqué par revêtement par étalement « bar coating **».**

### Seconde variante

Si la fonction électronique est constituée de motifs nécessitant le passage par des étapes de photolithographie ou l'utilisation de matériaux élaborés à des températures supérieures à 100°C, le substrat temporaire peut être préparé comme suit :
Un substrat de support 110 non altéré par les étapes de fabrication de la fonction électronique est utilisé. Un tel substrat peut être un substrat en silicium ou en verre.

Une couche dite sacrificielle ou intermédiaire 120 est déposée sur le substrat permanent (110), par exemple par enduction centrifuge.

Une couche temporaire 130 est ensuite déposée sur la couche sacrificielle 120 par exemple par enduction centrifuge.

La couche sacrificielle 120 présente la propriété d'être facilement dissolvable, par exemple dans un solvant tel que l'acétone, et ou d'avoir un faible pouvoir d'adhésion avec la couche temporaire 130.

La couche temporaire 130 est mécaniquement flexible et peut être facilement gravable, par exemple par gravure plasma, et / ou dissolvable dans un bain chimique et / ou facilement détachable de la couche sacrificielle 120.

La Figure 1 schématise les deux variantes d'obtention du substrat temporaire 100.

### (b) Choix d'un conformateur

La Figure 2 montre une représentation schématique d'un conformateur reconfigurable.

Le procédé de la présente invention utilise un conformateur convexe qui permet d'obtenir une pièce structurale concave.

Afin de pouvoir également obtenir une pièce structurale convexe, on utilise un conformateur reconfigurable. Un tel conformateur 410 est appliqué sur un socle 420.

Le conformateur 410 présente une zone que l'on peut déformer (image 1) de telle sorte que l'on conduira les étapes (e) et (f) dans la configuration dans laquelle la zone présente une forme convexe (images 2 et 3). Puis avant l'étape (g), on modifiera la forme de la zone déformable de telle sorte qu'elle prenne une forme concave (image 4).

Le matériau du conformateur reconfigurable doit présenter la capacité de se déformer. On peut par exemple utiliser un élastomère de type polydiméthylsiloxane commercialisé sous la dénomination Sylgard 184. La zone déformable peut se présenter sous la forme d'une membrane dont l'épaisseur peut varier de 100 à 500 µm.

### (c) Formation de la fonction électronique

Les fonctions électroniques sont fabriquées sur le substrat temporaire 100 qui convient à la fonction électronique en fonction de son procédé de fabrication, tel que cela est indiqué ci-dessus.

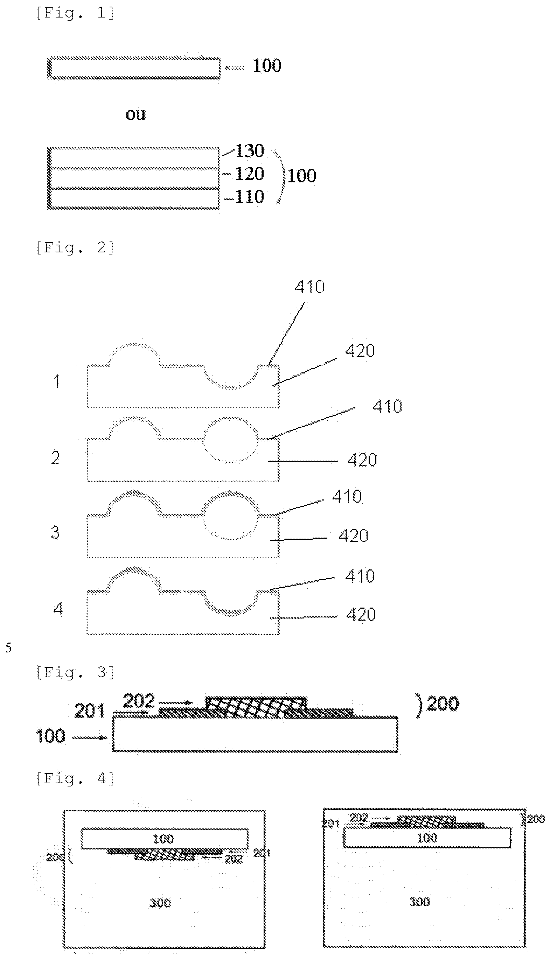

La fonction électronique 200 peut être constituée d'un seul motif ou d'une superposition de motifs électroniques 2021 et 202, tel que cela est représenté schématiquement sur la Figure **3****.**

### (d) Placement du substrat temporaire dans un bain liquide

Le substrat temporaire 100 est déposé à la surface du bain de liquide selon deux variantes. Dans les deux cas, le liquide 300 du bain doit permettre de dissoudre le substrat temporaire 100. Les deux variantes sont représentées schématiquement sur la Figure **4****.**

### Première variante

Dans cette variante, les fonctions électroniques 200 sont en contact avec le liquide 300. Le substrat temporaire 100 va se dissoudre pour former un film de substrat temporaire sous lequel se trouveront les fonctions électroniques 200.

### Seconde variante

Dans cette variante, les fonctions électroniques 200 ne sont pas directement en contact avec le liquide 300., le substrat temporaire 100 va se dissoudre pour former un film de substrat temporaire entre les fonctions électroniques 200 et le liquide 300.

### (e) Transfert de la fonction électronique et du film portant cette dernière

Cette étape a pour but de transférer les fonctions électroniques 200 sur la surface libre du conformateur 400 tout en laissant une couche de substrat temporaire à l'état liquide intercalée entre les fonctions électroniques 200 et le conformateur 400.

Dans une première variante, le liquide du bain monte jusqu'à atteindre le conformateur.

Dans une deuxième variante, le conformateur plonge dans le bain de liquide.

Dans une troisième variante, le conformateur est plongé dans le bain de liquide et le liquide descend jusqu'à atteindre la surface du conformateur.

Dans une quatrième variante, le conformateur est plongé dans le bain de liquide et monte jusqu'à passer à travers le film de substrat temporaire.

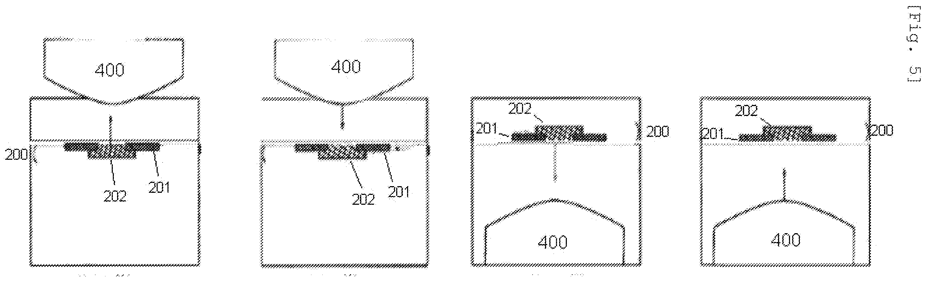

La Figure 5 représente de gauche à droite chacune de ces variantes.

### (f) Retrait du conformateur du bain

Le conformateur est retiré du bain après que le film de substrat temporaire et les fonctions électroniques ont été déposés à sa surface.

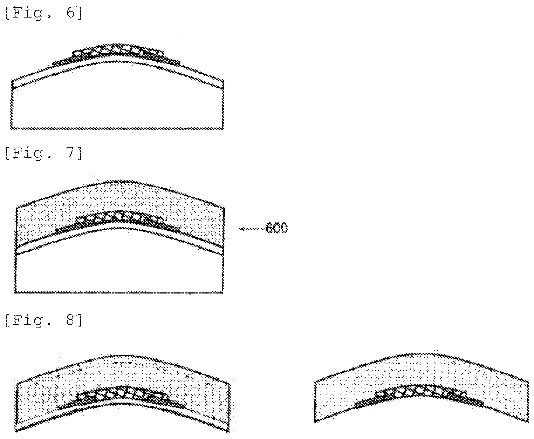

On met le conformateur ainsi obtenu à sécher afin de faire solidifier la couche de substrat temporaire. La pièce obtenue est représentée schématiquement sur la Figure 6.

### (g) Moulage d'une pièce à fonction électronique

Une pièce structurale 600 est formée par moulage 600 sur le conformateur 400.

Le moulage peut être effectué par les technologies de moulage bien connues de l'homme du métier, telles que l'injection plastique ou les procédés de conception de pièces composites, tels que l'infusion sous vide.

Le moulage de la pièce structurale est représenté de façon schématique sur la Figure 7.

### (h) Retrait du conformateur et obtention de la pièce finale

La couche temporaire permet de conduire le démoulage de la pièce structurale 600 sans endommagement de la fonction électronique. La couche temporaire peut ensuite être gravée ou est conservée en fonction de l'application souhaitée.

La Figure 8 représente schématiquement les pièces obtenues sans (à gauche) et avec (à droite) retrait de la couche temporaire.

La pièce présente une forme concave avec les fonctions électroniques à sa surface.

### Exemple 1

### (a) Formation du substrat temporaire

On s'est procuré une feuille de poly(alcool de vinyle) (PVA) commercialisée sous la dénomination Hydrographics PXA4 de Desgn Plus. L'épaisseur de cette feuille est de 30 µm.

### (b) Choix d'un conformateur

On prévoit de réaliser une pièce en forme de demi-sphère (forme à titre d'exemple).

### (c) Formation de la fonction électronique

La fonction électronique a été imprimée sur la feuille de PVA par sérigraphie. Des encres conductrices et isolantes commercialisée par la société Dupont ont été utilisée. Les contacts mécaniques et électriques des composants ont été réalisés par dispense de colles époxy conductrices, commercialisées sous la dénomination CW2400 de RS radiospare.

### (d) Placement du substrat temporaire dans un bain liquide

(d1)
On place le substrat temporaire dans un bain d'eau chauffé à 30°C.

Le substrat temporaire est introduit dans le bain du côté de la feuille de PVA de telle sorte que le substrat temporaire forme un film sur la surface du bain, la fonction électronique se trouvant sous le film de PVA.

(d2)
On place le substrat temporaire dans un bain d'eau chauffé à 30°C.

Le substrat temporaire est introduit dans le bain du côté de la fonction électronique de telle sorte que le substrat temporaire forme un film sur la surface du bain, la fonction électronique se trouvant sur le film de PVA.

### (e) Transfert de la fonction électronique et du film portant cette dernière

(e1)
Le substrat temporaire est placé tel que décrit à l'étape (d1).

On place le conformateur au-dessus du bain liquide, la surface convexe de ce dernier étant tournée vers la surface du bain liquide.

On fait monter le niveau du bain liquide de telle sorte que la surface du bain atteint la surface convexe du conformateur pour y transférer le film de PVA et la fonction électronique.

(e2)
Le substrat temporaire est placé tel que décrit à l'étape (d1).

On place le conformateur au-dessus du bain liquide, la surface convexe de ce dernier étant tournée vers la surface du bain liquide.

On fait plonger le conformateur dans le bain liquide de telle sorte que le film de PVA et la fonction électronique sont transférés sur la surface convexe du conformateur.

(e3)
Le substrat temporaire est placé tel que décrit à l'étape (d2).

On place le conformateur dans le fond du bain liquide, la surface convexe de ce dernier étant tournée vers la surface du bain liquide.

On fait descendre le niveau du bain liquide de telle sorte que la surface du bain atteint la surface convexe du conformateur pour y transférer le film de PVA et la fonction électronique.

(e4)
Le substrat temporaire est placé tel que décrit à l'étape (d2).

On place le conformateur dans le fond du bain liquide, la surface convexe de ce dernier étant tournée vers la surface du bain liquide.

On fait monter le conformateur dans le bain liquide vers la surface du bain de telle sorte que le film de PVA et la fonction électronique sont transférés sur la surface convexe du conformateur.

### (f) Retrait du conformateur du bain

On retire le conformateur portant le film temporaire et la fonction électronique du bain liquide et on fait sécher l'ensemble pendant 60 minutes à une température de 30°C pour faire durcir à nouveau le film temporaire pour former une couche temporaire entre la fonction électronique et la surface du conformateur.

### (g) Moulage d'une pièce à fonction électronique

On prépare un moulage sur la surface convexe du conformateur portant la fonction électronique et la couche temporaire.

La pièce moulée peut être obtenue à l'aide d'une résine commercialisée sous la dénomination SRinfugree 810 de la société Sicomin mélangée avec son durcisseur commercialisé sous la référence SD8824 de la société Sicomin, la résine est chargée en fibres de verre.

### (h) Retrait du conformateur et obtention de la pièce finale

Une fois la pièce moulée obtenue à l'étape (g), elle est retirée du conformateur, la couche temporaire servant de couche de démoulage pour ne pas dégrader la fonction électronique. La couche temporaire est ensuite retirée par gravure.

La pièce obtenue est recuite pendant 3 heures ) 100°C pour obtenir une pièce rigide.

### Exemple 2

### (a) Formation du substrat temporaire

On a fabriqué le substrat temporaire de la façon suivante.

Sur un substrat de support constitué par une feuille de verre, on a appliqué par enduction centrifuge (« spin coating ») une couche intermédiaire de poly (méthacrylate de méthyle) (PMMA). Le PMMA est le PMMA A11 de la société Mircochem dilué à 50 % en poids avec de l'anisole. Les conditions d'enduction pour la fabrication d'une couche intermédiaire de 1 µm sont les suivantes :
- temps d'enduction : 30 s ;
- vitesse d'enduction : 4000 tr/min
- accélération : 5000 tr/min².

La couche intermédiaire est recuite pendant 3 minutes à 100°C.

On a ensuite appliqué une couche temporaire sur la couche intermédiaire enduction centrifuge. La couche temporaire est une couche de polyimide. Le polyimide est un polyimide commercialisé sous la dénomination Durimide 7320 par la société Fujifilm dilué à 25 % en poids dans de l'anisole. Les conditions d'enduction pour la fabrication d'une couche temporaire de 1 µm sont les suivantes :
- temps d'enduction : 30 s ;
- vitesse d'enduction : 300 tr/min
- accélération : 5000 tr/min².

### (b) Choix d'un conformateur

On procède comme à l'Exemple **1.**

### (c) Formation de la fonction électronique

(c1)
On procède comme à l'étape (c) de l'Exemple 1.

(c2)
Obtention d'une couche semi-conductrice

Un silicium dopé de type N est déposé par dépôt chimique en phase vapeur assisté par plasma (PECVD) sur la couche temporaire. Les conditions de dépôt sont les suivantes :
SiH₄ 1,5 Sccm (centimètres cubes standard par minute), Ar 75 Sccm, H₂ 75 Sccm, AsH₃ 10 Sccm puissance RF 15W, température 165°C, pression 0,9 mbar.

Le temps de dépôt est optimisé pour obtenir une couche d'une épaisseur de 90 nm.

Le dépôt est suivi d'une étape de photolithographie puis de gravure plasma avec les paramètres de gravure suivants :
SF6 50 Sccm, pression 30 mTorr, puissance RF 50W.

### Obtention d'une couche conductrice (prise de contact)

De l'aluminium est déposé par évaporation thermique pour obtenir une couche de 150 nm puis gravé par une solution d'acide orthophosphorique.

### (d) Placement du substrat temporaire dans un bain liquide

On place le substrat temporaire dans un bain d'eau chauffé à 30°C.

On plonge le substrat dans le bain du côté du substrat de support. Le substrat de support et sa couche intermédiaire tombe dans le fond du bain de telle sorte que la couche temporaire forme un film sur la surface du bain, la fonction électronique se trouvant sur le film de couche temporaire.

### (e) Transfert de la fonction électronique et du film portant cette dernière

On procède comme aux étapes (e1) ou (e2) de l'Exemple **1.**

### (f) Retrait du conformateur du bain

On procède comme à l'étape (f) de l'Exemple **1.**

### (g) Moulage d'une pièce à fonction électronique

On procède comme à l'étape (g) de l'Exemple **1.**

### (h) Retrait du conformateur et obtention de la pièce finale

On procède comme à l'étape (h) de l'Exemple **1.**

### Exemple 3

### (a) Formation du substrat temporaire

On procède comme à l'étape (a) de l'Exemple **1.**

### (b) Choix d'un conformateur

Le conformateur reconfigurable est obtenu par injection d'un matériau déformable (du polydiméthylsiloxane (pdms) dans notre exemple) entre un moule et un contre-moule aux géométries adaptées à la fabrication de la pièce finale.

### (c) Formation de la fonction électronique

On procède comme à l'étape (c) de l'Exemple **1.**

### (d) Placement du substrat temporaire dans un bain liquide

On procède comme à l'étape (d) de l'Exemple **1.**

### (e) Transfert de la fonction électronique et du film portant cette dernière

On procède comme à l'étape (e) de l'Exemple **1.**

### (f) Retrait du conformateur du bain

On procède comme à l'étape (f) de l'Exemple **1.**

### (g) Moulage d'une pièce à fonction électronique

On procède comme à l'étape (g) de l'Exemple **1.**

### (h) Retrait du conformateur et obtention de la pièce finale

On procède comme à l'étape (h) de l'Exemple **1.**

### Exemple 4 : application pour la fabrication de jauge de contrainte.

On a réalisé un substrat temporaire comme à l'Exemple **2.**

On a réalisé les fonctions électroniques comme à l'Exemple 2, les fonctions électroniques devant détecter les déformations du matériau de la pièce structurale. Les fonctions électroniques sont alors des jauges de contrainte composées de silicium et / ou de métal

Les étapes suivantes sont ensuite réalisées selon l'Exemple **2.**

### Exemple 5 : application pour la fabrication d'antenne.

On a réalisé un substrat temporaire comme aux Exemples 1 ou **2.**

On a réalisé les fonctions électroniques comme aux Exemples 1 ou 2, les fonctions électroniques devant être des éléments rayonnants

Les étapes suivantes sont ensuite réalisées selon les Exemples 1 ou **2.**

### Exemple 6 : application pour la fabrication de carte de circuit imprimé.

On a réalisé un substrat temporaire comme aux Exemples 1 ou **2.**

On a réalisé les fonctions électroniques comme aux Exemples 1 ou 2, les fonctions électroniques étant des interconnexions.

Les étapes suivantes sont ensuite réalisées selon les Exemples 1 ou 2.

Une fois la pièce fabriquée, on peut relier entre elles les interconnexions par un composant monté (CMS). Le montage du CMS est assuré par une soudure conductrice réalisée par une colle conductrice époxy.

## Revendications

1. - Procédé d'obtention d'une pièce (600) à fonction électronique intégrée, ladite pièce (600) présentant au moins une région de surface concave dans laquelle on souhaite placer une fonction électronique, comprenant les étapes consistant à :
(a) se procurer un substrat temporaire flexible (100) fait d'un matériau apte à se dissoudre dans un bain de liquide (300) tout en restant à sa surface et à revenir à son état préalable par séchage une fois sorti du bain ;
(b) se procurer un conformateur (400) présentant au moins une région de surface convexe apte à s'apparier avec ladite au moins une région de surface concave à la manière de deux parties complémentaires d'un moule ;
(c) former une fonction électronique (200) sur l'une des faces du substrat temporaire (100) ;
(d) placer le substrat temporaire (100) portant la fonction électronique (200) dans le bain de liquide (300) afin de former un film liquide sur la surface du bain de liquide (300) ;
(e) transférer la fonction électronique (200) et le film qui la porte sur ladite au moins une surface convexe du conformateur (400), de façon à former la succession suivante : - conformateur - couche de substrat temporaire - fonction électronique ;
(f) retirer le conformateur (400) du bain de liquide (300) et faire sécher pour faire revenir le substrat temporaire à son état initial ;
**caractérisé par le fait qu'**il comprend également les étapes suivantes :
(g) mouler la pièce (600) sur le conformateur (400) pour former la succession suivante : - conformateur - couche de substrat temporaire - fonction électronique - pièce ;
(h) retirer le conformateur (400) afin d'obtenir la pièce (600) à fonction électronique intégrée revêtue du substrat temporaire, lequel peut être conservé en tant que substrat de recouvrement de la fonction électronique, ou être retiré.

2. - Procédé selon la revendication 1, **caractérisé par le fait que** l'on utilise, comme substrat temporaire (100), une feuille de poly(alcool de vinyle).

3. - Procédé selon la revendication 1, **caractérisé par le fait que** l'on forme sur un substrat de support (110), une couche de substrat temporaire (130) avec interposition d'une couche sacrificielle (120), ayant la propriété de se dissoudre facilement dans le bain de liquide et / ou un pouvoir d'adhésion faible ou nul avec la couche de substrat temporaire (130), et on utilise cet assemblage pour conduire l'étape (c), puis on amène la couche de support (110) et la couche sacrificielle (120) à être retirées à l'étape (d).

4. - Procédé selon la revendication 3, **caractérisé par le fait que** la couche sacrificielle (120) est une couche non-adhésive en poly(méthacrylate de méthyle).

5. - Procédé selon l'une des revendications 1 à 4, **caractérisé par le fait que** l'on utilise un conformateur (400) constitué par une pièce métallique, en matière plastique, en composite ou en silicone.

6. - Procédé selon l'une des revendications 1 à 5, **caractérisé par le fait que** l'on forme la fonction électronique (200) par une technique choisie parmi l'impression par jet d'encre, la sérigraphie, le marquage par estampage et la photolithographie.

7. - Procédé selon l'une des revendications 1 à 6, **caractérisé par le fait que** le bain de liquide (300) est un bain d'eau à une température de 25 à 40°C.

8. - Procédé selon l'une des revendications 1 à 7, **caractérisé par le fait qu'**à l'étape (d), la fonction électronique (200) est :
- placée sur le film formé sur la surface du bain (300) de liquide, et
∘ à l'étape (e), le conformateur (400) est placé dans le fond du bain de liquide (300) et le conformateur (400) remonte à la surface du bain de liquide (300) ou la surface du bain de liquide (300) descend afin de transférer la fonction électronique (200) et le film qui la porte sur ladite au moins une surface convexe du conformateur (400) ;
ou
- placée sous le film formé sur la surface du bain de liquide (300), et
∘ à l'étape (e), le conformateur (400) est placé au-dessus du bain de liquide (300) et le conformateur (400) plonge dans le bain de liquide (300) ou la surface du bain de liquide (300) monte afin de transférer la fonction électronique (200) et le film qui la porte sur ladite au moins une surface convexe du conformateur (400).

9. - Procédé selon l'une des revendications 1 à 8, **caractérisé par le fait que** l'on conduit le séchage de l'étape (f) à une température de 25 à 60°C pendant une durée de 5 heures à 30 minutes.

10. - Procédé selon l'une des revendications 1 à 9, **caractérisé par le fait que** l'on conduit le moulage de l'étape (g) à partir d'une résine compatible avec les procédés de moulage, de fabrication de matériaux composites.

11. - Procédé selon l'une des revendications 1 à 10, suivant lequel la pièce comporte également au moins une région de surface convexe dans laquelle on souhaite également placer une fonction électronique, **caractérisé par le fait que** :
- à l'étape (b), on se procure un conformateur (410) en un matériau capable de se déformer pour permettre de le conformer avec la ou les formes concaves et avec la ou les formes convexes souhaitées pour s'apparier avec les formes complémentaires de la pièce à construire ;
- avant l'étape (e), on déforme le conformateur (410) pour que toutes ses régions déformables soient des régions convexes ;
- on conduit l'étape (e) comme indiqué à la revendication 1 ;
- avant l'étape (g), on déforme la ou les régions qui doit(doivent) correspondre aux régions convexes de la pièce pour qu'elle(s) aie(nt) une forme concave.

12. - Procédé selon la revendication 11, **caractérisé par le fait que** l'on utilise un conformateur (410) formé par une feuille d'élastomère, tel que du polydiméthylsiloxane.

13. - Procédé selon l'une des revendications 11 et 12, **caractérisé par le fait que** l'on utilise un conformateur (410) à l'état appliqué sur un socle (420) de forme complémentaire de la pièce que l'on veut obtenir, ledit socle (420) n'étant pas modifié au cours du procédé.

14. - Procédé selon la revendication 13, **caractérisé par le fait que** le socle (420) est formé d'une pièce métallique, en matière plastique, en composite ou en silicone.

## Patentansprüche

1. - Verfahren zum Erlangen eines Teils (600) mit integrierter elektronischer Funktion, wobei das Teil (600) mindestens einen konkaven Oberflächenbereich aufweist, in dem eine elektronische Funktion platziert werden soll, umfassend die Schritte, die aus Folgendem bestehen
(a) Bereitstellen eines flexiblen temporären Substrats (100) aus einem Material, das in der Lage ist, sich in einem Flüssigkeitsbad (300) aufzulösen, während es auf seiner Oberfläche verbleibt, und nach Verlassen des Bads durch Trocknen wieder in seinen vorherigen Zustand zurückzukehren;
(b) Bereitstellen eines Formgebers (400), der mindestens einen konvexen Oberflächenbereich aufweist, der in der Lage ist, mit dem mindestens einen konkaven Oberflächenbereich in der Art von zwei komplementären Teilen einer Form zusammenzupassen;
(c) Bolden einer elektronischen Funktion (200) auf einer der Seiten des temporären Substrats (100);
(d) Platzieren des temporären Substrats (100), das die elektronische Funktion (200) trägt, in dem Flüssigkeitsbad (300), um einen Flüssigkeitsfilm auf der Oberfläche des Flüssigkeitsbads (300) zu bilden;
(e) Übertragen der elektronischen Funktion (200) und des Films, der sie trägt, auf die mindestens eine konvexe Oberfläche des Formgebers (400), um die folgende Abfolge zu bilden: Formgeber - temporäre Substratschicht - elektronische Funktion;
(f) Entfernen des Formgebers (400) aus dem Flüssigkeitsbad (300) und Trocknenlassen, um das temporäre Substrat wieder in seinen ursprünglichen Zustand zu versetzen;
**dadurch gekennzeichnet, dass** es auch die folgenden Schritte umfasst:
(g) Formen des Teils (600) auf dem Formgeber (400), um die folgende Abfolge zu bilden: - Formgeber - temporäre Substratschicht - elektronische Funktion - Teil;
(h) Entfernen des Formgebers (400), um das Teil (600) mit integrierter elektronischer Funktion zu erlangen, das mit dem temporären Substrat beschichtet ist, das als Substrat zur Abdeckung der elektronischen Funktion beibehalten oder entfernt werden kann.

2. - Verfahren nach Anspruch 1, **dadurch gekennzeichnet, dass** als temporäres Substrat (100) eine Folie aus Polyvinylalkohol verwendet wird.

3. - Verfahren nach Anspruch 1, **dadurch gekennzeichnet, dass** auf einem Trägersubstrat (110) eine temporäre Substratschicht (130) mit Einfügen einer zwischenliegenden Opferschicht (120) gebildet wird, die die Eigenschaft aufweist, sich leicht in dem Flüssigkeitsbad aufzulösen und/oder einer geringen oder keiner Adhäsionskraft mit der temporären Substratschicht (130), und diese Anordnung verwendet wird, um den Schritt (c) durchzuführen, dann wird bewirkt, dass die Trägerschicht (110) und die Opferschicht (120) in Schritt (d) entfernt werden.

4. - Verfahren nach Anspruch 3, **dadurch gekennzeichnet, dass** die Opferschicht (120) eine nichtklebende Schicht aus Poly(methylmethacrylat) ist.

5. - Verfahren nach einem der Ansprüche 1 bis 4, **dadurch gekennzeichnet, dass** ein Formgeber (400) verwendet wird, der aus einem Metall-, Kunststoff-, Verbundstoff-oder Silikonteil besteht.

6. - Verfahren nach einem der Ansprüche 1 bis 5, **dadurch gekennzeichnet, dass** die elektronische Funktion (200) durch eine Technik gebildet wird, die ausgewählt ist aus Tintenstrahldruck, Siebdruck, Prägedruck und Fotolithografie.

7. - Verfahren nach einem der Ansprüche 1 bis 6, **dadurch gekennzeichnet, dass** das Flüssigkeitsbad (300) ein Wasserbad mit einer Temperatur von 25 bis 40 °C ist.

8. - Verfahren nach einem der Ansprüche 1 bis 7, **dadurch gekennzeichnet, dass** in Schritt (d) die elektronische Funktion (200) wie folgt ist:
- platziert auf dem Film, der auf der Oberfläche des Flüssigkeitsbads (300) gebildet ist, und
∘ in Schritt (e) ist der Formgeber (400) in dem Boden des Flüssigkeitsbads (300) platziert und der Formgeber (400) steigt zu der Oberfläche des Flüssigkeitsbads (300) auf oder die Oberfläche des Flüssigkeitsbads (300) sinkt ab, um die elektronische Funktion (200) und den Film, der sie trägt, auf die mindestens eine konvexe Oberfläche des Formgebers (400) zu übertragen
oder
- platziert unter dem Film, der auf der Oberfläche des Flüssigkeitsbads (300) gebildet ist, und
∘ in Schritt (e) ist der Formgeber (400) über dem Flüssigkeitsbad (300) platziert und der Formgeber (400) taucht in das Flüssigkeitsbad (300) ein oder die Oberfläche des Flüssigkeitsbads (300) steigt an, um die elektronische Funktion (200) und den Film, der sie trägt, auf die mindestens eine konvexe Oberfläche des Formgebers (400) zu übertragen.

9. - Verfahren nach einem der Ansprüche 1 bis 8, **dadurch gekennzeichnet, dass** das Trocknen von Schritt (f) bei einer Temperatur von 25 bis 60 °C über einen Zeitraum von 5 Stunden bis 30 Minuten durchgeführt wird.

10. - Verfahren nach einem der Ansprüche 1 bis 9, **dadurch gekennzeichnet, dass** der Guss von Schritt (g) aus einem Harz durchgeführt wird, das mit dem Guss-, Herstellungsverfahren von Verbundwerkstoffen kompatibel ist.

11. - Verfahren nach einem der Ansprüche 1 bis 10, wobei das Teil auch mindestens einen konvexen Oberflächenbereich umfasst, in dem auch eine elektronische Funktion platziert werden soll, **dadurch gekennzeichnet, dass**:
- in Schritt (b) ein Formgeber (410) aus einem Material bereitgestellt wird, das in der Lage ist, verformt zu werden, um zu ermöglichen, dass es mit der/den konkaven Form(en) und mit der/den gewünschten konvexen Form(en) geformt wird, um mit den komplementären Formen des zu konstruierenden Teils zusammenzupassen;
- vor Schritt (e) der Formgeber (410) verformt wird, damit alle seine verformbaren Bereiche konvexe Bereiche sind;
- der Schritt (e) wie beschrieben in Anspruch 1 durchgeführt wird;
- vor Schritt (g) der/die Bereich(e), der/die den konvexen Bereichen des Teils entsprechen soll(en), verformt wird/werden, damit er/sie eine konkave Form aufweist/aufweisen.

12. - Verfahren nach Anspruch 11, **dadurch gekennzeichnet, dass** ein Formgeber (410) verwendet wird, der aus einer Elastomerfolie, wie beispielsweise Polydimethylsiloxan, gebildet ist.

13. - Verfahren nach einem der Ansprüche 11 und 12, **dadurch gekennzeichnet, dass** ein Formgeber (410) in angelegtem Zustand auf einem Sockel (420) mit komplementärer Form des zu erlangenden Teils verwendet wird, wobei der Sockel (420) im Verlauf des Verfahrens nicht modifiziert wird.

14. - Verfahren nach Anspruch 13, **dadurch gekennzeichnet, dass** der Sockel (420) aus einem Metall-, Kunststoff-, Verbund- oder Silikonteil gebildet ist.

## Claims

1. - A method of obtaining a part (600) with an integrated electronic function, said part (600) having at least one concave surface region in which an electronic function is to be placed, comprising the steps of:
(a) providing a flexible temporary substrate (100) made of a material capable of dissolving in a liquid bath (300) while remaining on its surface and returning to its previous state by drying once removed from the bath;
(b) providing a conformer (400) having at least one convex surface region capable of mating with said at least one concave surface region in the manner of two complementary parts of a mould;
(c) forming an electronic function (200) on one of the faces of the temporary substrate (100);
(d) placing the temporary substrate (100) carrying the electronic function (200) in the liquid bath (300) in order to form a liquid film on the surface of the liquid bath (300);
(e) transferring the electronic function (200) and the film carrying it onto said at least one convex surface of the conformer (400), so as to form the following sequence: - conformer - temporary substrate layer - electronic function;
(f) removing the conformer (400) from the liquid bath (300) and drying to return the temporary substrate to its initial state;
**characterised in that** it also comprises the following steps:
(g) moulding the part (600) onto the conformer (400) to form the following sequence: - conformer - temporary substrate layer - electronic function - part;
(h) removing the conformer (400) to obtain the part (600) with integrated electronic function coated with the temporary substrate, which may be retained as a covering substrate for the electronic function or removed.

2. - Method according to claim 1, **characterised in that** a polyvinyl alcohol film is used as the temporary substrate (100).

3. - Method according to claim 1, **characterised in that** a temporary substrate layer (130) is formed on a support substrate (110), with the interposition of a sacrificial layer (120) having the property of dissolving easily in the liquid bath and/or having low or no adhesion to the temporary substrate layer (130), and this assembly is used to carry out step (c), then the support layer (110) and the sacrificial layer (120) are removed in step (d).

4. - Process according to claim 3, **characterised in that** the sacrificial layer (120) is a non-adhesive layer of poly(methyl methacrylate).

5. - Process according to one of claims 1 to 4, **characterised in that** a conformer (400) consisting of a metal, plastic, composite or silicone part is used.

6. - Process according to one of claims 1 to 5, **characterised in that** the electronic function (200) is formed using a technique chosen from inkjet printing, screen printing, embossing and photolithography.

7. - Process according to one of claims 1 to 6, **characterised in that** the liquid bath (300) is a bath of water at a temperature of 25 to 40°C.

8. - Process according to one of claims 1 to 7, **characterised in that**, in step (d), the electronic function (200) is:
- placed on the film formed on the surface of the liquid bath (300), and
∘ in step (e), the conformer (400) is placed at the bottom of the liquid bath (300) and the conformer (400) rises to the surface of the liquid bath (300) or the surface of the liquid bath (300) descends in order to transfer the electronic function (200) and the film carrying it onto said at least one convex surface of the conformer (400);
or
- placed under the film formed on the surface of the liquid bath (300), and
∘ in step (e), the conformer (400) is placed above the liquid bath (300) and the conformer (400) plunges into the liquid bath (300) or the surface of the liquid bath (300) rises in order to transfer the electronic function (200) and the film carrying it onto said at least one convex surface of the conformer (400).

9. - Process according to one of claims 1 to 8, **characterised in that** the drying of step (f) is carried out at a temperature of 25 to 60°C for a period of 5 hours to 30 minutes.

10. - Process according to one of claims 1 to 9, **characterised in that** the moulding of step (g) is carried out using a resin compatible with moulding processes for manufacturing composite materials.

11. - Process according to one of claims 1 to 10, in which the part also comprises at least one convex surface region in which an electronic function is also to be placed, **characterised in that**:
- in step (b), a conformer (410) is obtained made of a material capable of deforming so that it can be conformed to the concave shape(s) and convex shape(s) desired to match the complementary shapes of the part to be constructed;
- before step (e), the conformer (410) is deformed so that all its deformable regions are convex regions;
- step (e) is carried out as indicated in claim 1;
- before step (g), the region(s) that must correspond to the convex regions of the part are deformed so that they have a concave shape.

12. - Method according to claim 11, **characterised in that** a conformer (410) formed by an elastomer sheet, such as polydimethylsiloxane, is used.

13. - Process according to one of claims 11 and 12, **characterised in that** a conformer (410) is used in the state applied to a base (420) of a shape complementary to the part to be obtained, said base (420) not being modified during the process.

14. - Process according to claim 13, **characterised in that** the base (420) is formed from a metal, plastic, composite or silicone part.
